# EUROPÄISCHE PATENTSCHRIFT

(11) **EP 2 504 149 B1**
(45) Veröffentlichungstag und Bekanntmachung des Hinweises auf die Patenterteilung: **01.07.2020**
(21) Anmeldenummer: 10792867.3
(22) Anmeldetag: 24.11.2010
(51) Int. Cl.: B29C 59/12, H01T 19/00, B05D 3/14

(54) **VERFAHREN ZUR OBERFLÄCHENBEHANDLUNG EINES SUBSTRATS UND VORRICHTUNG ZUR DURCHFÜHRUNG DES VERFAHRENS**
METHOD FOR SURFACE TREATING A SUBSTRATE AND DEVICE FOR CARRYING OUT THE METHOD
PROCÉDÉ DE TRAITEMENT DE SURFACE D'UN SUBSTRAT ET DISPOSITIF POUR LA MISE EN OEUVRE DU PROCÉDÉ

(30) Priorität: 24.11.2009 DE 102009044638; 02.09.2010 DE 202010008435 U
(43) Veröffentlichungstag der Anmeldung: 03.10.2012
(73) Patentinhaber: Kalwar CIV Innoserv GmbH & Co. KG, 33790 Halle/Westf. (DE)
(72) Erfinder: Kalwar, Klaus, 33803 Steinhagen (DE)
(74) Vertreter: Dantz, Jan Henning
(86) Internationale Anmeldenummer: PCT/EP2010/068150
(87) Internationale Veröffentlichungsnummer: WO 2011/064268

(56) Entgegenhaltungen:
- EP-A2- 0 160 889
- EP-B1- 0 279 371
- DE-A1-102005 050 094
- DE-C- 900 429
- US-A- 5 029 553
- US-A1- 2007 272 149
- US-A1- 2008 187 487
- US-A1- 2009 283 671

## Beschreibung

Die Erfindung betrifft ein Verfahren zur Oberflächenbehandlung eines Substrats nach dem Oberbegriff des Anspruchs 1 sowie eine Vorrichtung zur Durchführung des Verfahrens.

Aus der EP 0 279 371 B1, die den Oberbegriff des Ansprüche 1 und den Oberbegriff des Anspruchs 5 offenbart, ist bekannt, die Oberfläche eines Kunststoffs mit Aerosolen zu beaufschlagen, um eine verbesserte und gleichmäßigere Haftfähigkeit für eine nachfolgende Beschichtung zu erreichen oder, bei entsprechender Modifikation der Aerosole die Oberfläche des Kunststoffs direkt zu beschichten.

Im ersten Fall kann beispielsweise Wasser zu Aerosolen zerstäubt werden, während im zweiten Fall, also bei einer unmittelbaren Beschichtung der Kunststoffoberfläche geeignete Lösungen zum Einsatz kommen.

Zur Erzeugung der Korona-Entladung sind zwei abständig zueinander angeordnete Elektroden erforderlich, von denen mindestens eine mit hoher Spannung beaufschlagt ist, während die andere an Masse anliegt. In den Entladungsbereich, der durch eine zwischen einer Korona-Elektrode und dem Substrat gebildeten etwa ≤ 2 mm breiten Wirkspalt definiert ist, werden die Aerosole eingesprüht. Die Korona-Behandlung selbst ist aus dem einschlägigen Stand der Technik, beispielsweise aus der genannten EP 0 279 371 B1 bekannt, so dass hierauf ausdrücklich Bezug genommen wird.

Systembedingt sind die zur Erzeugung der Aerosole eingesetzten Zerstäuber nicht in der Lage hinsichtlich ihrer Größe gleichmäßige Aerosole zu liefern, d.h., es werden unterschiedlich große Aerosole hergestellt. Wie sich gezeigt hat, führt dies zu einer Beeinträchtigung der Oberflächenbehandlung des Substrats, sowohl hinsichtlich der Erzeugung von Adhäsionskräften, mit der Bildung unterschiedlich starker Haftungsnester, wie auch hinsichtlich eines Beschichtungsauftrags, wenn die Aerosole zum unmittelbaren Beschichten der Oberfläche des Substrats vorgesehen sind.

In diesem Zusammenhang ist zu bemerken, dass die Versprühung der Aerosole quasi von oben her, also in Richtung der Schwerkraft auf das darunterliegende Substrat erfolgt, ebenso wie die Korona-Entladung selbst durch eine entsprechende Anordnung der dem Zerstäuber zugeordneten Sprühdüsen bzw. der Elektroden.

In der gattungsfremden EP 0 160 889 A2 ist ein Verfahren zur Oberflächenbehandlung eines Substrats mittels einer elektrischen Korona-Entladung thematisiert, bei dem eine Flüssigkeit als Korona-Elektrode fungiert, die unter Druck aus einem Elektrodenprofil austritt und bevorzugt elektrisch gut leitfähig ist, wobei das Elektrodenprofil unterseitig zu einer Trägerelektrode angeordnet ist.

Entgegen einem gattungsgemäßen Verfahren, bei dem zwischen der Korona-Elektrode und dem Substrat ein Wirkspalt gebildet ist, ist die bekannte sozusagen Flüssigkeits-Elektrode zum Substrat spaltfrei, d.h., diese Elektrode berührt das Substrat unmittelbar.

Um eine Korona-Entladung zu erhalten, ist ein kontinuierlicher Zulauf von Flüssigkeit erforderlich, die im Übrigen elektrisch gut leitfähig sein soll. D.h., zwischen dem Elektrodenprofil, aus dem die Flüssigkeit austritt, und dem Substrat muss eine ständige Flüssigkeits-Wand aufgebaut sein, um die Korona-Entladung zu bewirken.

Allerdings ist das aus dieser Literatur bekannte Verfahren aus vielerlei Gründen nicht praktikabel. So stehen Teile der Vorrichtung dauerhaft unter Spannung, was hinsichtlich der Arbeitssicherheit nicht akzeptabel ist. Zwar wird empfohlen, die Trägerelektrode aus einem elektroisolierenden Werkstoff herzustellen und die Zuführleitung für die Flüssigkeit von einem Vorratsbehältnis elektrisch zu isolieren, jedoch muss dieses Behältnis aufgefüllt werden, was bei Weiterbetrieb der Anlage lebensgefährlich ist. In diesem Fall ist es geboten, den Produktionsablauf zu unterbrechen und die gesamte Vorrichtung abzuschalten, was den Betrieb der Vorrichtung und die Durchführung dieses Verfahrens unwirtschaftlich macht.

In diesem Sinn ist auch anzusehen, dass eine Abtrocknung der an dem Substrat anhaftenden Flüssigkeit nicht in einer gewünschten Zeit möglich ist. Des Weiteren haftet die aufgebrachte Flüssigkeit nicht vollständig am Substrat an, so dass entsprechende Auffangmaßnahmen für ablaufende Flüssigkeit getroffen werden müssen. Trotzdem kann eine Beaufschlagung von Bauteilen mit ablaufender Flüssigkeit nicht verhindert werden, die letztendlich entsprechend häufig Reinigungsarbeiten erfordert und diese Bauteile insgesamt in Mitleidenschaft zieht.

Der Erfindung liegt die Aufgabe zugrunde, ein Verfahren der gattungsgemäßen Art sowie eine Vorrichtung zur Durchführung des Verfahrens so weiterzuentwickeln, dass die Beschichtungs- bzw. Haftungsqualität der Oberfläche des Substrats wesentlich verbessert wird.

Diese Aufgabe wird durch ein Verfahren mit den Merkmalen des Anspruchs 1 sowie eine Vorrichtung mit den Merkmalen des Anspruchs 5 gelöst.

Wie sich überraschend gezeigt hat, wird durch das Aufsprühen der Aerosole in den Entladungsbereich von unten her entgegen der Schwerkraftrichtung eine wesentliche Verbesserung der Oberflächenbehandlung des Substrats erreicht, die sich vor allem auch in einer visuell erkennbaren gleichmäßigeren Beschichtung zeigt.

Das Substrat wird dabei im Durchlauf an einer Trägerfläche einer Trägerelektrode anliegend unterhalb einer durch die Trägerelektrode geführten gedachten horizontalen Ebene während der Entladung bewegt.

Möglicherweise werden die größeren Aerosole nicht bis zur Oberfläche geführt, so dass lediglich Aerosole innerhalb eines hinsichtlich ihrer Größe unerheblich differierenden Bereichs zur Anlage bzw. zur Wirkung kommen. Erkennbar jedenfalls ist eine signifikante Ergebnisverbesserung, sowohl bei der Erzeugung von Adhäsionskräften, wie auch bei der Erzeugung einer Beschichtung, bei der Beschichtungsbestandteile als Lösungen auf die Oberfläche des Substrats gesprüht werden.

Bei der Erzeugung von Adhäsionskräften ergibt sich eine Gleichmäßigkeit der Haftfähigkeit der Oberfläche, die eine nachfolgende Bearbeitung, beispielsweise eine Beschichtung, erlaubt, mit einer durchgehend gleichbleibenden Qualität.

Naturgemäß führt dies zu einer Ausschussminimierung und damit einer erheblichen Kostenreduzierung, die insofern bedeutsam ist, als die behandelten Substrate üblicherweise als Serienprodukte in großen Stückzahlen bzw. großen Mengen hergestellt werden.

Überdies ist das neue Verfahren praktisch ohne Mehrkosten zu realisieren und gegenüber dem Stand der Technik mit einer ohne Mehraufwand anzupassenden Vorrichtung durchführbar. D.h., das neue Verfahren ist quasi kostenneutral.

Im Übrigen ist das Verfahren bei allen geeigneten Substraten einsetzbar, also sowohl bei Kunststoffen, Metallen, Holz oder Holzwerkstoffen oder dergleichen. Ebenso bei Bahnen oder formstabilen Körpern, wie Platten, Profile oder dergleichen.

Als Aerosole können, wie bereits erwähnt, Flüssigkeiten unterschiedlichster Art zur Anwendung kommen, sowohl hinsichtlich der Flüssigkeit selbst wie auch hinsichtlich der Aerosol-Beschaffenheit.

Die Vorrichtung zur Durchführung des Verfahrens weist mindestens zwei Korona-Elektroden auf, von denen eine an Spannung und die andere an Masse anliegt, wobei eine Korona-Elektrode eine Trägerelektrode bildet mit einer Trägerfläche, an der das Substrat anliegt. Mittels eines Zerstäubers werden Aerosole in den durch einen Wirkspalt gebildeten Entladungsbereich der Korona-Elektroden gesprüht, so dass die frei liegende, der Trägerelektrode abgewandte Oberfläche des Substrats der Korona-Behandlung unterzogen wird.

Erfindungsgemäß bildet die nach unten gerichtete Fläche der Trägerelektrode die Trägerfläche, so dass die Aerosole mittels des Zerstäubers praktisch von unten nach oben in den Entladungsbereich gesprüht werden, im Wesentlichen entgegen der Schwerkraftrichtung.

Während im gattungsbildenden Stand der Technik der Entladungsbereich oberhalb einer gedachten, durch die Trägerelektrode geführten horizontalen Ebene herausgebildet ist, ist dieser Entladungsbereich gemäß der neuen Vorrichtung unterhalb dieser horizontalen Ebene.

Prinzipiell ist die neue Vorrichtung dadurch zu realisieren, dass die der Trägerelektrode abständig zugeordnete andere Korona-Elektrode als Gegenelektrode lediglich um 180° gedreht anzuordnen ist. Insoweit werden aufwendige konstruktive Änderungen vermieden, wodurch die neue Vorrichtung praktisch ohne Mehrkosten herstellbar ist.

Bevorzugt wird die Vorrichtung zumindest in dem Bereich, in dem Aerosole als Nebel vorliegen und nicht am Substrat anhaften, eingehaust und damit die Bestandteile der Aerosole einer Wiederverwendung zugänglich gemacht. Abgesehen von den wirtschaftlichen Vorteilen, die sich dann einstellen, wenn die Aerosole mit Additiven befrachtet sind, die nach einer Rückgewinnung erneut in den Behandlungsprozess überführt werden, gelangen Aerosole durch die Kapselung der Vorrichtung nicht in die Umgebung, wodurch eine mögliche Personengefährdung durch Einatmen von Aerosolen mit beispielsweise Nano-Partikeln als Additive wirksam verhindert wird.

Weitere vorteilhafte Ausbildungen der Erfindung sind in den Unteransprüchen gekennzeichnet.

Das erfindungsgemäße Verfahren sowie eine Vorrichtung zur Durchführung des Verfahrens werden nachfolgend nochmals anhand der beigefügten Zeichnungen beschrieben.

Es zeigen:
- Figur 1: eine Vorrichtung zur Durchführung des Verfahrens in einer schematischen Seitenansicht
- Figur 2: einen Teil der Vorrichtung, ebenfalls in einer schematischen Seitenansicht
- Figur 3: einen Teilausschnitt eines nach dem Verfahren hergestellten Substrats in einer geschnittenen Seitenansicht.

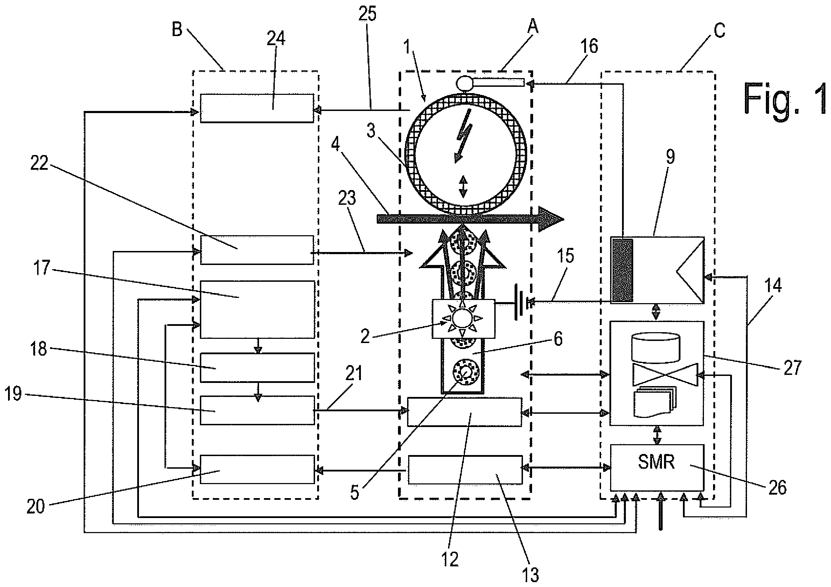

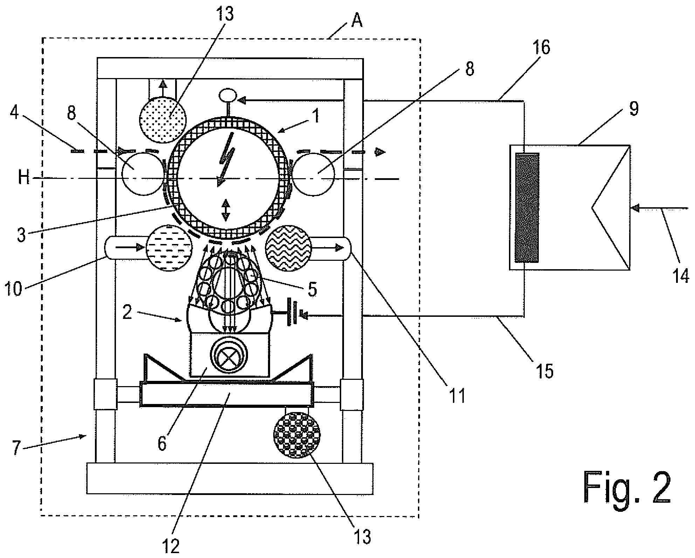

In den Figuren 1 und 2 ist eine Vorrichtung zur Oberflächenbehandlung eines Substrats 4 dargestellt, das im Beispiel als zu beschichtende Kunststofffolie ausgebildet ist.

Die in der Figur 1 gezeigte Vorrichtung ist zur Vereinfachung in drei Abschnitte A, B, C unterteilt, wobei die Abschnitte B und C jeweils ein Blockschaltbild wiedergeben, zur Verdeutlichung des Verfahrens.

Der Abschnitt A findet sich als Ausschnitt in der Figur 2 wieder.

Die Oberflächenbehandlung erfolgt mittels einer elektrischen Korona-Entladung, wozu zwei Korona-Elektroden vorgesehen sind, von denen eine als Trägerelektrode 1 über eine Leitung 16 an einen Hochspannung erzeugenden, mit einer Stromleitung 14 verbundenen Generator 9 angeschlossen ist, während die andere Korona-Elektrode über eine Masseleitung 15 als Gegenelektrode 2 an Masse anliegt. Selbstverständlich können stattdessen die Gegenelektrode 2 an Spannung und die Trägerelektrode 1 an Masse anliegen.

Die Gegenelektrode 2 ist, bezogen auf eine horizontale, durch die Trägerelektrode 1 geführte Ebene H unterhalb der Trägerelektrode 1 angeordnet, an der das Substrat 4 an einer gebildeten Trägerfläche 3 anliegt.

In den durch Pfeile gekennzeichneten Entladungsbereich zwischen der Gegenelektrode 2 und der Trägerelektrode 1 werden mittels eines Zerstäubers 6 Aerosole 5 gesprüht, wobei die Düsen des Zerstäubers 6 im Bereich der Gegenelektrode 2 angeordnet sind, so dass die Aerosole im Wesentlichen entgegen der Schwerkraftrichtung eingebracht werden.

Durch die Korona-Entladung werden auf der freien Fläche des Substrats 4 Adhäsionskräfte erzeugt, durch die beispielsweise dann, wenn die Aerosole mit Additiven beaufschlagt sind, eine gleichmäßige Beschichtung der Substratoberfläche erfolgt.

Bestehen die Aerosole lediglich aus Wasser, wird durch die Erfindung eine außerordentlich gleichmäßige Haftfähigkeit der freien Oberfläche des Substrats 4 erreicht, für eine nachfolgende Beschichtung, beispielsweise einen Lackauftrag, einen Druck oder dergleichen.

Im Übrigen sind die als Walze ausgebildete Trägerelektrode 1, die Gegenelektrode 2, der Zerstäuber 6 ebenso in einem Gestell 7 angeordnet, wie beidseitig und achsparallel zur Trägerelektrode 1 verlaufende Stützwalzen 8, über die das Substrat 4 geführt wird.

Im Entladungsbereich sind weiter zur Bearbeitungsklimasicherung eine Zuluftleitung 10 und eine Abluftleitung 11 installiert.

Der Zerstäuber 6 sowie die Gegenelektrode 2 als Baueinheit sind in einer Abstützung 12 gehalten, die als Sammelbehälter ausgebildet ist, in dem überschüssige Aerosole bzw. Partikel gesammelt und über einen Anschluss 13 dem Stoffkreislauf zurückgeführt wird.

Die Gegenelektrode 2 besteht vorzugsweise aus wenigstens einem vorzugsweise verseilten Draht, der über Führungs- und Stellmittel, bezogen auf die Breite des durchgeführten Substrats verstellbar ist.

Für die Qualität der Korona-Entladung bzw. der Beschichtung mittels der mit Additiven angereicherten Aerosole ist es erforderlich, während des Betriebs eine Reinigung der Gegenelektrode 2 durchzuführen. Dazu wird die Gegenelektrode 2 insbesondere reversierend während der Korona-Entladung durch eine Reinigungseinrichtung bewegt. Eine solche Maßnahme ist jedoch nur möglich, wenn die Gegenelektrode 2 berührungssicher an Masse anliegt.

Während der Bereich A die Materialbehandlung wiedergibt, sind in dem Bereich B schematisch die Versorgungsmittel dargestellt, und im Bereich C die Prozessfunktionen.

Dem Bereich B ist ein Versorgungsbehälter 17 zugeordnet, in dem die zur Aerosol-Beschichtung zu verarbeitenden Stoffe bevorratet und aufbereitet werden. Zu recycelnde Stoffe werden über den Anschluss 13 nach einer Filterung und Reinigung sowie einer Durchsatzmessung 20 dem Versorgungsbehälter 17 zugeführt.

Vom Versorgungsbehälter 17 wird der Beschichtungsstoff im Durchsatz über eine Messeinrichtung 18 zur Aerosolbildung durch Mehrstoffverdüsung 19 über eine Leitung 21 und die Abstützung 12 in den Zerstäuber 6 transportiert.

Mithilfe eines Lüfters 22 wird über eine Luftzufuhr 23 Luft zur Zuluftleitung 10 geführt, während eine an die Abluftleitung 11 angeschlossene Abluftführung 25 einem Ablüfter 24 abgesaugte Luft zuführt.

Im Bereich C schließlich sind als Prozessfunktionsteile eine Schaltzentrale 26 und eine Datenerfassung 27 mit Verarbeitung und Ausgabe für den gesamten Anlageprozess zugeordnet, wobei die Funktionsteile zur Prozessfunktion C mit den jeweiligen Bauteilen der Gesamtanlage in Wirkverbindung stehen.

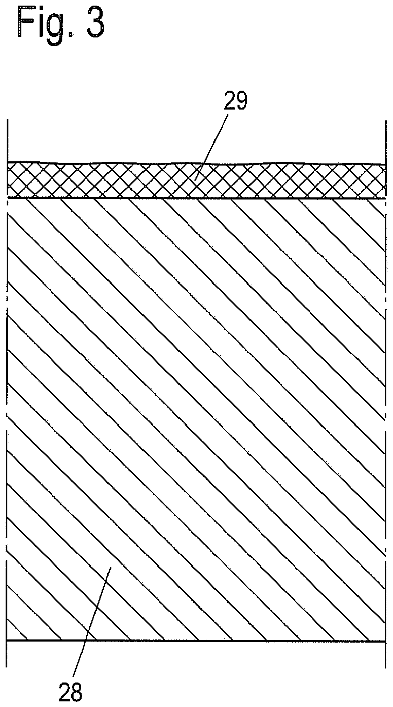

In der Figur 3 ist als ein nach dem erfindungsgemäßen Verfahren mit einer Beschichtung 29 versehenes Substrat 28 in einem stark vergrößerten und von den tatsächlichen Proportionen abweichenden Querschnitt dargestellt, das in Form einer Folie, vorzugsweise aus Kunststoff, vorliegt, die auf einer Seite mit der Beschichtung 29 versehen ist, die in einer Dicke von ≤ 200 nm, vorzugsweise ≤ 150 nm aufgebracht ist.

Es ist erkennbar, dass die Beschichtung 29 eine weitgehend gleichmäßige Schichtdicke aufweist, wobei lediglich deren Oberfläche eine geringe Rauigkeit besitzt, die jedoch für die gedachten Einsatzzwecke unerheblich ist.

Prinzipiell denkbar ist auch, die gegenüberliegende Seite des Substrats 28 ebenfalls mit einer Beschichtung 29 zu versehen.

Die Herstellung der Beschichtung 29 mittels des neuen Verfahrens führt zu einem bezüglich der Schichtdicke sehr gleichmäßigen Auftrag, wobei die Additive aus vorbereiteten Partikeln bestehen können, die in einem Durchmesser von 0,1 nm - 1 mm vorliegen.

Die Aushärtung bzw. Trocknung kann auf unterschiedliche Art und Weise erfolgen, je nach Beschaffenheit der aufgetragenen Beschichtung 29. So ist eine Wärme/Luftbehandlung oder eine Strahlenaushärtung mit Elektronenstrahlhärtung (ESH), UV-Licht, Infrarotlicht oder mittels einer Plasmakorona-Behandlung denkbar, jeweils in Einzelbehandlungen oder in Kombinationen, die zu Vernetzungsreaktionen führen.

Durch die Schichtdicke von bevorzugt ≤ 150 nm ist ein sehr geringer Materialauftrag zur Beschichtung möglich, bei gleichzeitiger Wirkoptimierung aufgrund der gleichmäßigen Schichtdicke.

Wie sich überraschend gezeigt hat, kann die Materialmenge der Additive um einen wesentlichen Faktor reduziert werden, was sich insoweit als besonders vorteilhaft darstellt, als Additive relativ teure Grundstoffe sind.

Darüber hinaus kann die Durchlaufgeschwindigkeit der Vorrichtung, mit der die Beschichtung 29 aufgebracht wird, erhöht werden, so dass der Produktionsausstoß in einem Umfang gesteigert wird, der durchaus als signifikant bezeichnet werden kann.

Im Übrigen ist durch die weitgehend gleichmäßige Schichtdicke eine Verbesserung der Eigenschaften der Beschichtung 29 bei bestimmten Anwendungsfällen gegeben. Auch besteht die Möglichkeit einer Qualitätsüberwachung bei der Beschichtung 29, die bislang in diesem Umfang nicht möglich war.

Prinzipiell lassen sich mehrere Schichten auftragen, die jeweils in einer erfindungsgemäßen Dicke vorliegen.

### Bezugszeichenliste

- 1: Trägerelektrode
- 2: Gegenelektrode
- 3: Trägerfläche
- 4: Substrat
- 5: Aerosole
- 6: Zerstäuber
- 7: Gestell
- 8: Stützwalze
- 9: Generator
- 10: Zuluftleitung
- 11: Abluftleitung
- 12: Abstützung
- 13: Anschluss
- 14: Stromleitung
- 15: Masseleitung
- 16: Leitung
- 17: Versorgungsbehälter
- 18: Messeinrichtung
- 19: Mehrstoffverdüsung
- 20: Durchsatzmessung
- 21: Leitung
- 22: Lüfter
- 23: Luftzufuhr
- 24: Ablüfter
- 25: Abluftführung
- 26: Schaltzentrale
- 27: Datenerfassung
- 28: Substrat
- 29: Beschichtung

## Patentansprüche

1. Verfahren zur Oberflächenbehandlung eines Substrats (4, 28) mittels einer elektrischen Korona-Entladung, wobei in den durch einen zwischen einer Korona-Elektrode und dem Substrat (4, 28) gebildeten Wirkspalt definierten Entladungsbereich während der Entladung Aerosole (5) gesprüht werden, **dadurch gekennzeichnet, dass** das Sprühen der Aerosole (5) im Wesentlichen entgegen der Schwerkraftrichtung erfolgt und dass das Substrat (4, 28) im Durchlauf an einer Trägerfläche (3) einer Trägerelektrode (1) anliegend unterhalb einer durch die Trägerelektrode (1) geführten gedachten horizontalen Ebene (H) während der Entladung bewegt wird.

2. Verfahren nach Anspruch 1, **dadurch gekennzeichnet, dass** die Aerosole (5) in Form von Wasser, einer wässrigen Lösung oder mit Additiven aufgesprüht werden.

3. Verfahren nach einem der vorhergehenden Ansprüche, **dadurch gekennzeichnet, dass** eine zur Trägerelektrode (1) in Korrespondenz stehende Gegenelektrode (2) während der Korona-Entladung gereinigt wird.

4. Verfahren nach einem der vorhergehenden Ansprüche, **dadurch gekennzeichnet, dass** überschüssige, nicht der Beschichtung (29) zugeführte Flüssigkeiten und/oder Additive wiederverwertet werden.

5. Vorrichtung zur Durchführung des Verfahrens nach Anspruch 1, mit mindestens zwei Korona-Elektroden, von denen eine an Spannung und die andere an Masse anliegt, und eine der Korona-Elektroden eine Trägerelektrode (1) mit einer Trägerfläche (3) für das Substrat (4) und die andere eine Gegenelektrode bilden, wobei ein Zerstäuber (6) vorgesehen ist, mit dem Aerosole (5) in den Entladungsbereich der Korona-Elektroden sprühbar sind, **dadurch gekennzeichnet, dass** die nach unten gerichtete Fläche der Trägerelektrode (1) die Trägerfläche (3) bildet.

6. Vorrichtung nach Anspruch 5, **dadurch gekennzeichnet, dass** der Zerstäuber (6) im Bereich der Gegenelektrode (2) angeordnet ist.

7. Vorrichtung nach Anspruch 5 oder 6, **dadurch gekennzeichnet, dass** die Trägerelektrode (1) als Walzenelektrode ausgebildet ist.

8. Vorrichtung nach einem der Ansprüche 5 - 7, **dadurch gekennzeichnet, dass** beidseitig der Trägerelektrode (1) achsparallel dazu verlaufend Stützwalzen (8) angeordnet sind.

9. Vorrichtung nach einem der Ansprüche 5 - 8, **dadurch gekennzeichnet, dass** die Trägerelektrode (1) an Spannung und die Gegenelektrode (2) an Masse anliegen.

10. Vorrichtung nach einem der Ansprüche 5-9, **dadurch gekennzeichnet, dass** die Gegenelektrode (2) als vorzugsweise verseilte Drahtelektrode ausgebildet ist.

11. Vorrichtung nach einem der Ansprüche 5 - 10, **dadurch gekennzeichnet, dass** eine Reinigungseinrichtung vorgesehen ist, mittels derer die Gegenelektrode (2) reinigbar ist.

## Claims

1. Method for surface treating a substrate (4, 28) by means of an electrical corona discharge, wherein aerosols (5) are sprayed during the discharge into the discharge region defined by an active gap formed between a corona electrode and the substrate (4, 28), **characterized in that** the spraying of the aerosols (5) takes place substantially against the direction of gravity and **in that** the substrate (4, 28) is moved during the discharge in passage in continuous contact with a carrier surface (3) of a carrier electrode (1) below an imaginary horizontal plane (H) guided through the carrier electrode (1).

2. Method according to claim 1, **characterized in that** the aerosols (5) are sprayed on in the form of water, an aqueous solution or with additives.

3. Method according to one of the preceding claims, **characterized in that** a counter-electrode (2) corresponding to the carrier electrode (1) is cleaned during the corona discharge.

4. Method according to one of the preceding claims, **characterized in that** excess liquids and/or additives not supplied to the coating (29) are recycled.

5. Device for carrying out the method according to claim 1, having at least two corona electrodes, one of which is connected to voltage and the other to earth, and one of the corona electrodes forms a carrier electrode (1) with a carrier surface (3) for the substrate (4) and the other forms a counter-electrode, wherein an atomizer (6) is provided with which aerosols (5) can be sprayed into the discharge region of the corona electrodes, **characterized in that** the downwardly facing surface of the carrier electrode (1) forms the carrier surface (3).

6. Device according to claim 5, **characterized in that** the atomizer (6) is arranged in the region of the counter-electrode (2).

7. Device according to claim 5 or 6, **characterized in that** the carrier electrode (1) is designed as a roller electrode.

8. Device according to one of claims 5 to 7, **characterized in that** support rollers (8) are arranged on both sides of the carrier electrode (1) and extend axially parallel thereto.

9. Device according to one of the claims 5 to 8, **characterized in that** the carrier electrode (1) is connected to voltage and the counter-electrode (2) is connected to earth.

10. Device according to one of the claims 5 to 9, **characterized in that** the counter-electrode (2) is designed as a preferably stranded wire electrode.

11. Device according to one of the claims 5 to 10, **characterized in that** a cleaning device is provided by means of which the counter-electrode (2) can be cleaned.

## Revendications

1. Procédé de traitement de surface d'un substrat (4, 28) au moyen d'une décharge électrique de type corona, dans lequel des aérosols (5) sont pulvérisés dans la zone de décharge définie par un espace actif formé entre une électrode à effet corona et le substrat (4, 28) pendant la décharge, caractérisé en ce en ce que la pulvérisation des aérosols (5) s'effectue sensiblement à l'encontre de la direction de la force de gravité, et que le substrat (4, 28) est déplacé en continu pendant la décharge, en étant appliqué contre une surface porteuse (3) d'une électrode porteuse (1), en dessous d'un plan horizontal imaginaire (H) passant à travers l'électrode porteuse (1).

2. Procédé selon la revendication 1, **caractérisé en ce que** les aérosols (5) sont pulvérisés sous forme d'eau, d'une solution aqueuse ou avec des additifs.

3. Procédé selon l'une des revendications précédentes, **caractérisé en ce qu'**une contre-électrode (2) en correspondance avec l'électrode porteuse (1) est nettoyée pendant la décharge corona.

4. Procédé selon l'une des revendications précédentes, **caractérisé en ce que** les liquides et/ou additifs excédentaires non amenés au revêtement (29) sont recyclés.

5. Dispositif pour mettre en œuvre le procédé selon la revendication 1, avec au moins deux électrodes à effet corona, dont l'une est reliée à la tension et l'autre à la masse, et l'une des électrodes à effet corona forme une électrode porteuse (1) avec une surface porteuse (3) pour le substrat (4) et l'autre forme une contre-électrode, un moyen de pulvérisation (6) étant prévu, avec lequel des aérosols (5) peuvent être pulvérisés dans la zone de décharge des électrodes à effet corona, **caractérisé en ce que** la surface dirigée vers le bas de l'électrode porteuse (1) forme la surface porteuse (3).

6. Dispositif selon la revendication 5, **caractérisé en ce que** le moyen de pulvérisation (6) est disposé dans la zone de la contre-électrode (2).

7. Dispositif selon la revendication 5 ou 6, **caractérisé en ce que** l'électrode porteuse (1) est réalisée sous la forme d'une électrode-rouleau.

8. Dispositif selon l'une des revendications 5 à 7, **caractérisé en ce que** des rouleaux d'appui (8) sont disposés des deux côtés de l'électrode porteuse (1) en s'étendent de manière axialement parallèle à celle-ci.

9. Dispositif selon l'une des revendications 5 à 8, **caractérisé en ce que** l'électrode porteuse (1) est reliée à la tension et la contre-électrode (2) à la masse.

10. Dispositif selon l'une des revendications 5 à 9, **caractérisé en ce que** la contre-électrode (2) est réalisée sous la forme d'un fil-électrode de préférence torsadé.

11. Dispositif selon l'une des revendications 5 à 10, **caractérisé en ce qu'**un moyen de nettoyage est prévu, à l'aide duquel la contre-électrode (2) peut être nettoyée.
